# FASCICULE DE BREVET EUROPEEN

(11) **EP 4 106 012 B1**
(45) Date de publication et mention de la délivrance du brevet: **17.09.2025**
(21) Numéro de dépôt: 22020286.5
(22) Date de dépôt: 15.06.2022
(51) Int. Cl.: H10F 77/20, H10F 77/30

(54) **REVÊTEMENT ANTI-ÉBLOUISSEMENT DE NANOSTRUCTURE D'OXYDE À LARGE BANDE INTERDITE ET SON UTILISATION**
BLENDFREIE BESCHICHTUNG AUS OXID-NANOSTRUKTUR MIT GROSSEM BANDABSTAND UND IHRE VERWENDUNG
ANTI-GLARE COATING FOR PROHIBITED WIDE BANDGAP OXIDE NANOSTRUCTURE AND USE THEREOF

(30) Priorité: 15.06.2021 FR 2106340
(43) Date de publication de la demande: 21.12.2022
(73) Titulaire: Nanovation, 78117 Châteaufort (FR)
(72) Inventeur: Rogers, David J., 10300 Sainte Savine (FR); Hosseini-Teherani, Ferechteh, 91400 Orsay (FR); Sandana, Vinod Eric, 95140 Garges-Lès-Gonesse (FR); Bove, Philippe Henri, 91190 Gif sur Yvette (FR)
(74) Mandataire: Setayesh Bamas, Sousan

(56) Documents cités:
- WITZE ALEXANDRA: "SpaceX tests black satellite to reduce 'megaconstellation' threat to astronomy", NATURE, NATURE PUBLISHING GROUP UK, LONDON, vol. 577, no. 7790, 1 January 2020 (2020-01-01), pages 303, XP036988530, ISSN: 0028-0836, [retrieved on 20200109], DOI: 10.1038/D41586-020-00041-4
- BAI ANQI ET AL: "Efficient photon capturing in Cu(In,Ga)Se2thin film solar cells with ZnO nanorod arrays as an antireflective coating", CHEMICAL PHYSICS LETTERS, ELSEVIER BV, NL, vol. 636, 30 July 2015 (2015-07-30), pages 134 - 140, XP029272999, ISSN: 0009-2614, DOI: 10.1016/J.CPLETT.2015.07.044
- PODMORE HUGH ET AL: "Increasing solar cell power production on micro and nano satellites using sub-wavelength gratings", 2015 IEEE AEROSPACE CONFERENCE, IEEE, 7 March 2015 (2015-03-07), pages 1 - 7, XP032782808, ISBN: 978-1-4799-5379-0, [retrieved on 20150605], DOI: 10.1109/AERO.2015.7118884
- SZÁZ DÉNES ET AL: "Polarized light pollution of matte solar panels: anti-reflective photovoltaics reduce polarized light pollution but benefit only some aquatic insects", JOURNAL OF INSECT CONSERVATION, SPRINGER INTERNATIONAL PUBLISHING, CHAM, vol. 20, no. 4, 11 August 2016 (2016-08-11), pages 663 - 675, XP036053772, ISSN: 1366-638X, [retrieved on 20160811], DOI: 10.1007/S10841-016-9897-3

## Description

### Domaine technique

La présente invention a pour objet un revêtement anti-éblouissement nanostructuré d'oxyde à large bande interdite pour les panneaux solaires. Plus particulièrement, l'invention concerne un revêtement anti-éblouissement de matériaux nanostructuré d'oxyde à large bande interdite réalisé sur la grille de contacts métalliques à la surface des panneaux solaires des vaisseaux spatiaux.

Le domaine d'utilisation de la présente invention est sur les vaisseaux spatiaux et les satellites et en particulier dans les nanosatellites.

### Technique antérieure

Le document "SpaceX tests black satellite to reduce 'megaconstellation' threat to astronomy", NATURE, vol. 577, no. 7790, 1 janvier 2020, page 303, par Alexandra Witze, concerne un panneau solaire d'un satellite en orbite. Le document mentionne la réflexion lumineuse comme étant une source de pollution lumineuse sur les panneaux solaires de satellites.

Le document "Efficient photon capturing in Cu(In,Ga)Se2 thin film solar cells with ZnO nanorod arrays as an antireflective coating", CHEMICAL PHYSICS LETTERS, vol. 636, 30 juillet 2015, pages 134-140, par Anqi Bai et al., concerne des réseaux de nanotiges de ZnO de longueurs contrôlables préparés sur des cellules solaires Cu(In,Ga)Se2 2 en utilisant l'électrodéposition. Les qualités optiques ont été améliorées en diminuant le rapport surface/volume. Une diminution de la réflectance globale pondérée de la cellule solaire a été démontrée avec des nanotiges de ZnO comme revêtements antireflets. Les effets antireflets ont été optimisés en faisant varier les caractéristiques de structure des nanorods pour correspondre au profil d'indice de réfraction qui fournit la réduction la plus efficace de la réflexion.

Les revêtements antireflets (ARC) constitués de couches simples ou superposées de diélectriques forment la base de conception conventionnelle pour la suppression de la réflexion sur les « cover-glass » (verres protecteurs) sur les panneaux solaires spatiaux. Les revêtements nanostructurés permettent une plus grande flexibilité dans la conception et la fabrication de revêtements miniaturisés, ce qui a considérablement fait progresser le domaine des ARCs. En particulier, l'émergence de surfaces plasmoniques et de méta surfaces permet la réalisation de revêtements ARC à large bande et insensibles aux angles d'incidence, à un ordre de grandeur inférieur à celui des longueurs d'onde opérationnelles.

Un revêtement antireflet en forme de couche mince peut minimiser les réflexions sur une longueur d'onde spécifique, généralement à une incidence normale, ce qui limite son utilisation pour une large plage visible. En outre, de tels revêtements sont intrinsèquement incapables de présenter une réduction spectrale de réflectance sur une large plage d'angles d'incidence.

Les revêtements antireflets conventionnels simples, doubles ou multicouches sont limités par les exigences d'épaisseur. Cette limitation fondamentale retarde toute nouvelle amélioration de leurs performances, notamment en raison de la demande actuelle d'applications de faible épaisseur et de haut débit dans de nombreux dispositifs optoélectroniques. La nanofabrication et la nanophotonique ont mûri le domaine des ARCs. Ces nouvelles conceptions et approches pourraient améliorer les performances de nombreux appareils pour lesquels la réflexion de la lumière est indésirable, tels que les cellules solaires et les photodetecteurs. Cependant, la stabilité à long terme, la robustesse mécanique et le coût/complexité de fabrication des ARCs à base de plasmons et de méta surface restent des obstacles.

Les revêtements antireflets (ARC) constitués de bicouches de diélectriques sont couramment utilisés pour la suppression de la réflexion sur les « cover-glass » (verres protecteurs) des panneaux solaires spatiaux.

Cependant, la grille de contacts métalliques à la surface des panneaux solaires située en dessous de cover glasse, sur les vaisseaux spatiaux, réfléchie fortement, la lumière du soleil vers la Terre. Ce problème d'éblouissement est accru avec les nanosatellites (ou cubesats) parce qu'ils sont très nombreux et qu'ils n'ont pas de système de propulsion/pointage, donc ils tournent constamment sur eux-mêmes et ainsi reflètent la lumière du soleil de façon intermittente. Ce phénomène constitue une cause majeure de pollution lumineuse dans l'espace.

L'invention vise un revêtement permettant de résoudre le problème de la réflexion lumineuse des panneaux solaires embarqués dans des satellites. Plus particulièrement, l'invention vise un revêtement nanostructuré d'oxyde à large bande interdite afin de réduire les réflexions éblouissantes de la lumière avec un minimum de coût et une efficacité importante.

### EXPOSE DE L'INVENTION

Pour ce faire, l'invention propose un panneau solaire d'un vaisseau spatial ou satellite selon la revendication 1.

Selon des caractéristiques particulières dans l'électrodéposition, la grille de contacts métalliques constituant l'électrode négative ou la cathode étant obtenue directement dans une solution électrolyte, saturée en oxygène avec une électrode positive ou l'anode, , avec une charge constante entre l'anode et la cathode, grille de contacts métalliques. Un dépôt de matériaux d'oxyde nanostructurés sur la grille de contacts métalliques étant effectué à une température avoisinante de 70°C.

Selon des caractéristiques particulières, les nanostructures d'oxyde obtenues sont de morphologies telles que des 'nanofils' ou des 'nanocônes'.

Selon les caractéristiques particulières, les matériaux d'oxydes nanostructuré à large bande interdite sont choisi parmi ZnxOy ou ZnₓMg_{y}O_{z} ou ZnₓMg_{y}N_{z}O_{w} ou GaₓSi_{y}O_{z} ou GaₓO_{z} ou TiₓO_{z} ou MgₓO_{z} ou AlₓO_{z} ou SnₓO_{z}avec les indices x, y, z et w entre 1 à 3.

Selon un mode particulier de l'invention, le matériau d'oxide nanostructuré à large bande interdite est d'oxyde de zinc (ZnO).

L'invention concerne également, l'utilisation d'un panneau solaire dans un nanosatellite ou un vaisseau spatial, selon la revendication 6.

L'invention concerne en outre, un nanosatellite dont une grille de contacts métalliques à la surface de ses panneaux solaires est recouverte par un revêtement anti-éblouissement de matériaux nanostructurés d'oxyde défini ci-dessus.

### BREVE DESCRIPTION DES FIGURES

[Fig.1] illustre la réflexion lumineuse de la grille de contacts métalliques à la surface d'un panneau solaire de nanosatellite,
[Fig.2] illustre la technique d'électrodéposition d'une couche de nanofils ou de nanocônes de ZnO sur une grille de contactes métalliques,
[Fig.3] représente différentes morphologies de nanostructure d'oxyde de la présente invention susceptible de former un revêtement anti-éblouissement sur une grille de contact métallique,
[Fig.4] illustre l'effet de la lumière sur une nanostructure d'oxyde à large bande interdite en forme conique Fig 4A et Fig 4B,
[Fig.5] illustre l'image de la réflexion lumineuse, obtenue à partir de la terre, des satellites.

### DESCRIPTION DETAILLEE D'UN MODE DE REALISATION

Les matériaux nanostructurés d'oxydes à large bande interdite sont parmi les nanomatériaux les plus importants en raison des propriétés distinctives et de la relative facilitée de fabrication d'une multitude de variété de structures à faible coût. En effet, les oxydes à large bande interdite sont souvent physiquement et chimiquement stables. La grande gamme de leurs différentes propriétés font d'eux les matériaux de choix dans de nombreuses applications telles que les cellules photovoltaïques, les photodétecteurs, les électrodes transparentes, les générateurs ou récupérateurs d'énergie, les capteurs de gaz, les réacteurs photocatalytiques pour la dépollution de l'air et de l'eau, etc.

Il existe une grande variété de formes de nanostructures d'oxydes. Elles peuvent être d'origine naturelle, mais elles peuvent aussi être produites artificiellement via différents procédés physiques et/ou chimiques, en utilisant des procédés de croissance adéquats et en contrôlant la cinétique de croissance, la température de croissance locale et la composition chimique des précurseurs.

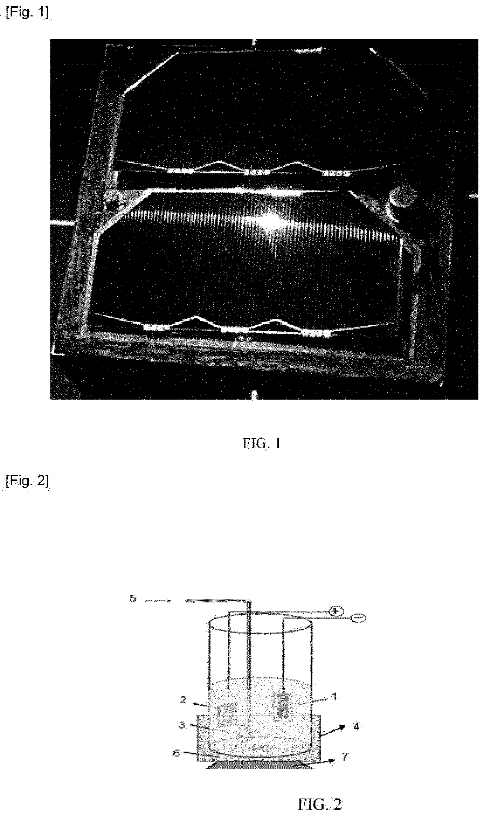

Figure 1 illustre l'image de la réflexion lumineuse par les surfaces métalliques d'un nanosatellite. En effet, se sont les contacts métalliques des panneaux solaires qui réfléchissent la lumière du soleil et ils sont la cause principale de la pollution lumineuse dans l'espace lorsque les satellites sont en orbite.

Pour réduire la réflexion lumineuse du soleil, le revêtement anti-éblouissement est réalisé directement sur ces grilles de contactes métalliques, car ceux sont les grilles de contactes métalliques qui réfléchissent la lumière du soleil. Pour la réalisation de ce revêtement, la grille de contactes métalliques agit entant que l'électrode positive dans l'électrodéposition.

Figure 2 illustre la technique d'électrodéposition d'une couche de nanofils de ZnO sur la grille de contacts électriques à la surface d'un panneau solaire d'un nanosatellite. La grille de contacts (1) agissantt comme une électrode négative (cathode) tandis que le zinc (2) sert d'électrode positive (anode). L'électrolyte (3) est constitué de Chlorure de Potassium (KCl) et de dimethyl hexamethylenetetramine. L'électrolyte (3) est saturé en oxygène avec un bubbler (5) (barboteur ou bulleur) d'oxygène moléculaire gazeux. L'ensemble est placé dans un recipient (4) dans un liquid (6) tel que l'eau ou autre. Le liquid est chauffé au moyen d'une plaque chauffant (7). Le dépôt par éléctrodéposition d'oxyde de zinc sur la grille de contacts se fait à basse temperature.

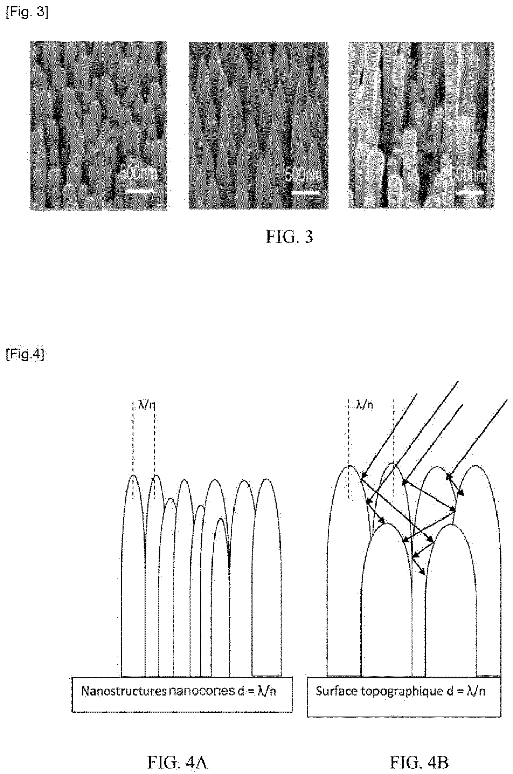

Figure 3 illustre le revêtement anti-éblouissement constitué de réseaux auto formés de nanostructures alignées de ZnO présentant diverses morphologies telles que des réseaux de nanofils ou encore de nanocônes. Parmi ceux-ci, la forme conique ou nanocône a montré des performances anti-éblouissement remarquables. La réflexion lumineuse pour ces formes coniques est inférieure à 0,5% pour tout le spectre visible sous des angles d'incidence allant jusqu'à 0.01° (degré).

L'efficacité anti-éblouissement des nanostructures d'oxydes réalisées selon la présente invention est fortement liée à la morphologie des nanocônes ainsi qu'à leur taille relative aux longueurs d'onde de la lumière incidente (Fig 4A). En effet, la largeur et l'espacement des nanocônes sont environ égaux à " λ /n" où λ est la longueur d'onde de la lumière incidente et n est l'indice de réfraction du matériau d'oxyde nanostructuré. Dans ces conditions nous avons remarqué que la réflexion de la lumière est inférieure ou égale à 0,5% même lorsque l'angle incident est rasant jusqu'à la valeur de 0.01 ° (Fig 4B). Cela montre l'efficacité anti-éblouissement du revêtement nanostructuré revendiqué dans la présente invention obtenue sur les grilles de contactes métalliques.

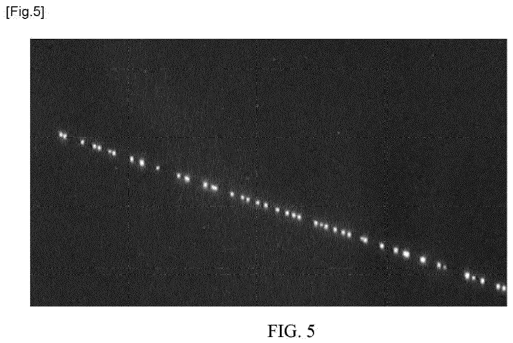

Figure 5 montre une image obtenue depuis la terre, des satellites positionnés sur orbite basse. Sur cette image, on remarque un train d'engins spatiaux aussi brillant que Polaris : l'étoile du nord. En effet, le problème spécifique des petits cubesatellites et nanosatellite est lié au manque de système de pointage/propulsion. Ainsi elles tournent constamment sur eux-mêmes et leurs surfaces métalliques réfléchissent, de façon intermittente, la lumière du soleil sur Terre.

Par conséquent, les revêtements anti-éblouissements de nanostructure d'oxyde à large bande interdite apportent une solution au problème de réflexion lumineuse, même aux grands angles incidence.

### Description d'un mode de réalisation de l'invention

Dans ce mode de réalisation, présenté sur la figure 2 un film nanostructuré de ZnO a été déposé sur la grille de contact métallique à la surface d'un panneau solaire de nanosatellite par éléctrodéposition, dans une solution électrolyte constitué de chlorure potassium (KCI) et de methyl hexamethylene tetramine entant que précurseur. Le dépôt est réalisé dans une température d'environ 70°C à l'aide de deux bornes de cellule électrochimique qui constituent d'électrodes positives et négatives. La grille de contactes métalliques (agit comme électrode négative (cathode) tandis que le zinc (zn) sert d'électrode positive (anode). L'expérience peut être réalisée en faisant varier la concentration de KCl, ainsi la longueur des nanofils ou des nanocônes augment en augmentant la concentration de KCl. Un bubbler (bulleur) (d'oxygène est utilisé afin de saturer l'électrolyte en oxygène et ainsi promouvoir l'oxydation de Zn. L'oxyde de zinc est ainsi déposé sur la grille de contacts métalliques dans une température relativement basse environ 70 °C. Cette technique de croissance de nanostructure par électrodéposition sur une gille de contacte métallique est particulièrement bien adaptée pour obtenir des couches nanostructurées de haute qualité à des températures de fabrication suffisamment basses pour être compatibles avec des supports sensibles à la température tels que les cellules solaires utilisées sur les satellites.

De plus, la lumière a une meilleure diffusion avec une surface plus rugueuse, composée de nanofils ou de nanocônes de ZnO. Cette dernière augmente le trajet du photon et améliore également l'absorption de la lumière par la réduction de la réflexion.

Le revêtement anti-éblouissement nanostructuré, selon la présente invention étant réalisé sur une grille de contacts métallique d'un panneau solaire est utilisée dans les vaisseaux spaciaux ou encore dans les nanosatellites, pour pourvoir réduire la réflexion de la lumière vers la terre. En effet, lorsque ces nanosatellites sont en orbite, ils tournent constamment sur eux-mêmes et réfléchissent la lumière sur terre. Lorsqu'ils sont équipés des panneaux solaires munis d'un revêtement anti-éblouissement sur leurs grilles de contacts métalliques, la réflexion est diminuée même pour les angles d'incidence rasants.

L'invention concerne, en particulier, les nanosatellites dont une grille de contacts métalliques à la surface de ses panneaux solaires est recouverte par un revêtement anti-éblouisement de matériaux nanostructuré d'oxyde, selon la présente invention.

L'avantage du revêtement anti-éblouissement de nanostructures d'oxyde à large bande interdite ainsi réalisé par éléctrodéposition ainsi réalisé selon la présente invention est qu'il est obtenu avec un minimum de coût dans une température relativement basse et avec une efficacité importante.

La technique d'électrodéposition avec la grille de contactes métalliques agissant en tant qu'électrode positive sur laquelle est déposée une couche de matériaux d'oxydes nanostructurés à large bande interdite est bien adapté pour résoudre le problème anti-éblouissement des nanostellites, lorsqu'ils sont en orbite basse.

## Revendications

1. Panneau solaire d'un vaisseau spatial ou satellite comprenant à sa surface une grille de contact métallique **caractérisé en ce que** la grille de contacts métalliques est recouverte d'un revêtement anti-éblouissement de matériau nanostructuré d'oxyde à large bande interdite pour réduire les réflexions éblouissantes de la lumière du soleil réalisé par l'électrodéposition d'une couche de matériau nanostructuré d'oxyde à large bande interdite sur ladite grille de contacts métalliques de sorte que la grille de contacts métalliques forme la cathode dans ce dépôt, et que les nanostructures obtenues ont une largeur et un espacement inférieur à la longueur d'onde 'λ' de la lumière incidente ou égale à « λ /n » avec λ située entre 180 nm et 8µm, et « n » étant l'indice de réfraction du matériau nanostructuré d'oxyde de sorte que pour des angles d'incidence compris entre 0.01 et 90 degrés moins de 0,5% de la lumière est réfléchie.

2. Panneau solaire d'un vaisseau spatial ou satellite selon la revendication 1 dans lequel la grille de contacts métalliques constituant l'électrode négative ou la cathode est obtenue directement dans une solution électrolyte, saturée en oxygène, avec une électrode positive ou l'anode, avec une charge constante entre l'anode ou l'électrode positive et la grille de contacts métalliques, et un dépôt de matériau nanostructuré d'oxyde sur la grille de contacts métalliques dans une température avoisinante de 70°C.

3. Panneau solaire d'un vaisseau spatial ou satellite selon la revendication 1 ou 2 **caractérisé en ce que** les nanostructures obtenues sont de morphologies telles que des 'nanofils' ou des 'nanocônes'.

4. Panneau solaire d'un vaisseau spatial ou satellite selon la revendication 1 ou 2 ou 3 dans lequel le matériau d'oxyde est choisi parmi ZnₓO_{y} ou ZnₓMg_{y}O_{z} ou ZnₓMg_{y}N_{z}O_{w} ou GaₓSi_{y}O_{z} ou GaₓO_{z} ou TiₓO_{z} ou MgₓO_{z} ou AlₓO_{z} ou SnₓO_{z} avec les indices x, y, z et w entre 1 à 3.

5. Panneau solaire d'un vaisseau spatial ou satellite selon les revendications 1 à 4 dans lequel le matériau d'oxyde est d'oxyde de zinc.

6. Utilisation du panneau solaire selon l'une des revendications 1-5 dans un nanosatellite ou un vaisseau spatial pour réduire les réflexions éblouissantes de la lumière du soleil et pour éviter la pollution lumineuse générée par le vaisseau spatial ou le nanosatellite.

7. Nanosatellite dont une grille de contacts métalliques à la surface de ses panneaux solaires est recouverte par un revêtement anti-éblouisement de matériau nanostructuré d'oxyde, les panneaux solaires étant selon l'une des revendications 1 à 5.

## Patentansprüche

1. Solarmodul eines Raumfahrzeugs oder Satelliten, das auf seiner Oberfläche ein metallisches Kontaktgitter aufweist, **dadurch gekennzeichnet, dass** das metallische Kontaktgitter mit einer blendfreien Beschichtung aus einem nanostrukturierten Oxidmaterial mit großer Bandlücke beschichtet ist, um Blendreflexionen des Sonnenlichts zu reduzieren, hergestellt durch Elektroabscheidung einer Schicht des nanostrukturierten Oxidmaterials mit großer Bandlücke auf das metallische Kontaktgitter, wobei das metallische Kontaktgitter während der Abscheidung als Kathode dient und die entstehenden Nanostrukturen eine Breite und einen Abstand kleiner als die Wellenlänge "λ" des einfallenden Lichts oder gleich "λ/n" aufweisen, wobei λ zwischen 180 nm und 8 µm liegt und "n" der Brechungsindex des nanostrukturierten Oxidmaterials mit großer Bandlücke ist, so dass bei Einfallswinkeln zwischen 0,01 und 90 Grad weniger als 0,5 % des Lichts reflektiert werden.

2. Solarmodul eines Raumfahrzeugs oder Satelliten nach Anspruch 1, wobei das metallische Kontaktgitter, das die negative Elektrode oder Kathode bildet, direkt in einer mit Sauerstoff gesättigten Elektrolytlösung mit einer positiven Elektrode oder Anode unter konstanter Belastung zwischen der Anode oder positiven Elektrode und dem metallischen Kontaktgitter hergestellt wird, und das nanostrukturierte Oxidmaterial mit großer Bandlücke bei einer Temperatur von etwa 70 °C auf das metallische Kontaktgitter abgeschieden wird.

3. Solarmodul eines Raumfahrzeugs oder Satelliten nach Anspruch 1 oder 2, **dadurch gekennzeichnet, dass** die entstehenden Nanostrukturen Morphologien wie "Nanodrähte" oder "Nanokegel" aufweisen.

4. Solarmodul eines Raumfahrzeugs oder Satelliten nach Anspruch 1, 2 oder 3, wobei das Oxidmaterial aus ZnxOy, ZnxMgyOz, ZnxMgyNzOw, GaxSiyOz, GaxOz, TixOz, MgxOz, AlxOz oder SnxOz ausgewählt wird, wobei die Indizes x, y, z und w zwischen 1 und 3 liegen.

5. Solarmodul eines Raumfahrzeugs oder Satelliten nach einem der Ansprüche 1 bis 4, wobei das Oxidmaterial Zinkoxid ist.

6. Verwendung des Solarmoduls nach einem der Ansprüche 1 bis 5 in einem Nanosatelliten oder Raumfahrzeug zur Reduzierung von Blendreflexionen des Sonnenlichts und zur Vermeidung von Lichtverschmutzung, die durch das Raumfahrzeug oder den Nanosatelliten verursacht wird.

7. Nanosatellit, bei dem ein metallisches Kontaktgitter auf der Oberfläche seiner Solarmodule mit einer blendfreien Beschichtung aus einem nanostrukturierten Oxidmaterial versehen ist, wobei die Solarmodule gemäß einem der Ansprüche 1 bis 5 ausgeführt sind.

## Claims

1. Solar panel of a spacecraft or satellite comprising on its surface a metallic contact grid, **characterized in that** the metallic contact grid is coated with an anti-glare coating of a wide bandgap oxide nanostructured material to reduce glare reflections of sunlight, produced by electrodeposition of a layer of the wide bandgap oxide nanostructured material onto said metallic contact grid such that the metallic contact grid acts as the cathode during deposition, and wherein the resulting nanostructures have a width and spacing smaller than the wavelength "λ" of the incident light or equal to "λ/n", where λ is between 180 nm and 8 µm, and "n" is the refractive index of the wide bandgap oxide nanostructured material, such that for angles of incidence between 0.01 and 90 degrees less than 0.5% of the light is reflected.

2. Solar panel of a spacecraft or satellite according to claim 1, wherein the metallic contact grid forming the negative electrode or cathode is obtained directly in an oxygen-saturated electrolyte solution with a positive electrode or anode, under constant load between the anode or positive electrode and the metallic contact grid, and with deposition of the wide bandgap oxide nanostructured material on the metallic contact grid at a temperature around 70°C.

3. Solar panel of a spacecraft or satellite according to claim 1 or 2, **characterized in that** the resulting nanostructures have morphologies such as 'nanowires' or 'nanocones'.

4. Solar panel of a spacecraft or satellite according to claim 1, 2, or 3, wherein the oxide material is selected from ZnxOy, ZnxMgyOz, ZnxMgyNzOw, GaxSiyOz, GaxOz, TixOz, MgxOz, AlxOz, or SnxOz, with indices x, y, z, and w between 1 and 3.

5. Solar panel of a spacecraft or satellite according to any one of claims 1 to 4, wherein the oxide material is zinc oxide.

6. Use of the solar panel according to any one of claims 1 to 5 in a nanosatellite or a spacecraft to reduce glare reflections of sunlight and to prevent light pollution generated by the spacecraft or nanosatellite.

7. Nanosatellite in which a metallic contact grid on the surface of its solar panels is coated with an anti-glare coating of a nanostructured oxide material, the solar panels being according to any one of claims 1 to 5.
